# EUROPEAN PATENT SPECIFICATION

(11) **EP 2 647 045 B1**
(45) Date of publication and mention of the grant of the patent: **25.12.2019**
(21) Application number: 11845225.9
(22) Date of filing: 18.11.2011
(51) Int. Cl.: H01L 23/48, H01L 23/28, H01L 21/683

(54) **LOW-PROFILE MICROELECTRONIC PACKAGE AND METHOD OF MANUFACTURING SAME**
FLACHES MIKROELEKTRONISCHES GEHÄUSE UND HERSTELLUNGSVERFAHREN DAFÜR
BOÎTIER MICRO-ÉLECTRONIQUE À BAS PROFIL ET PROCÉDÉ DE FABRICATION ASSOCIÉ

(30) Priority: 03.12.2010 US 959515
(43) Date of publication of application: 09.10.2013
(73) Proprietor: Intel Corporation, Santa Clara, CA 95054 (US)
(72) Inventor: MANUSHAROW, Mathew J., Phoenix, Arizona 85048 (US); NALLA, Ravi, San Jose, California 95117 (US)
(74) Representative: Rummler, Felix
(86) International application number: PCT/US2011/061338
(87) International publication number: WO 2012/074783

(56) References cited:
- US-A1- 2003 134 497
- US-A1- 2006 124 347
- US-A1- 2006 237 827
- US-A1- 2007 289 127
- US-A1- 2009 008 762
- US-A1- 2009 051 024
- US-A1- 2009 246 909
- US-A1- 2009 246 909
- US-B1- 6 506 632

## Description

### FIELD OF THE INVENTION

The disclosed embodiments of the invention relate generally to microelectronic devices, and relate more particularly to low profile packaging for microelectronic devices.

### BACKGROUND OF THE INVENTION

Microelectronic devices such as dies for computing applications and the like are housed in packages that, among other functions, enclose and protect the die or other device and also allow the device to be electrically connected to, for example, a printed circuit board or a similar structure. The long-standing trend toward size reduction in microelectronics operates for packaging just as for the packaged components, and this trend is especially pronounced for devices intended for mobile solutions. More specifically, low overall package height, sometimes referred to as z-height, is increasingly becoming a key requirement, both in mobile and in other market segments.

US 2006/0237827 A1, US 2009/0008762 A1 and US 6,506,632 B1 disclose embodiments pertaining to the preamble of claim 1.

### BRIEF DESCRIPTION OF THE DRAWINGS

The disclosed embodiments will be better understood from a reading of the following detailed description, taken in conjunction with the accompanying figures in the drawings of which only Figs. 3 and 7 show packages according to the invention, and Fig. 9 shows a flowchart illustrating a method of manufacturing such packages. The other figures and their corresponding text are not part of the invention and for background information only.

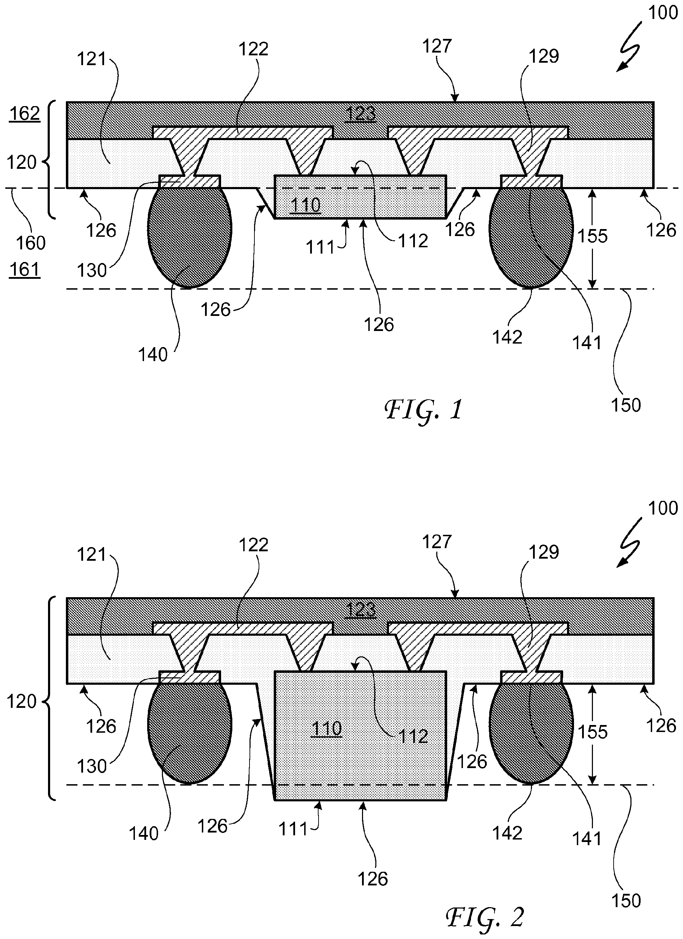

FIGS. 1-4 are cross-sectional views of a low-profile microelectronic package;

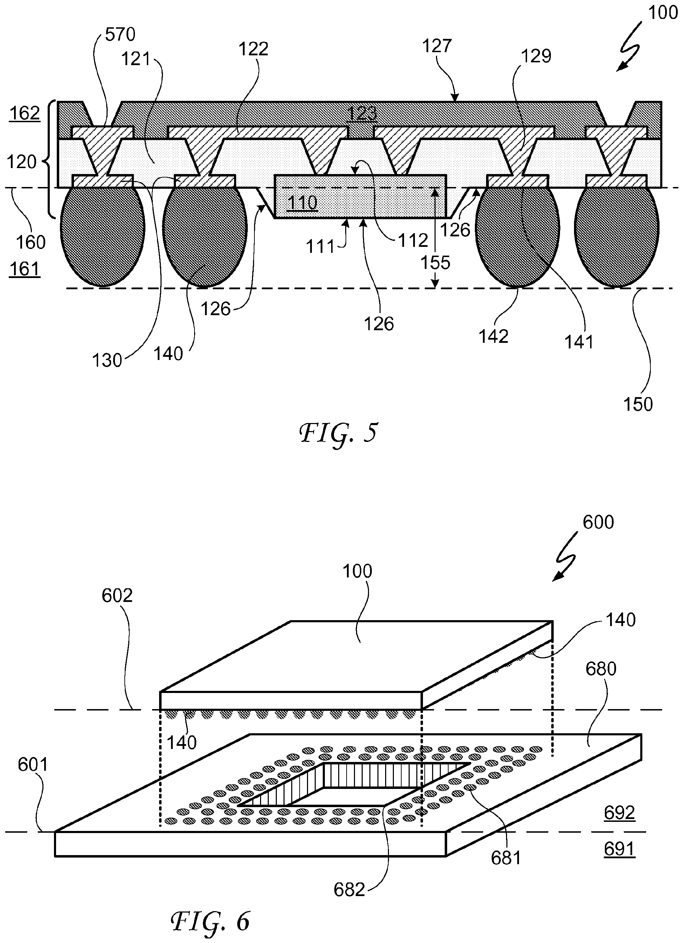

FIG. 5 is a cross-sectional view of a microelectronic package that enables a POP architecture;

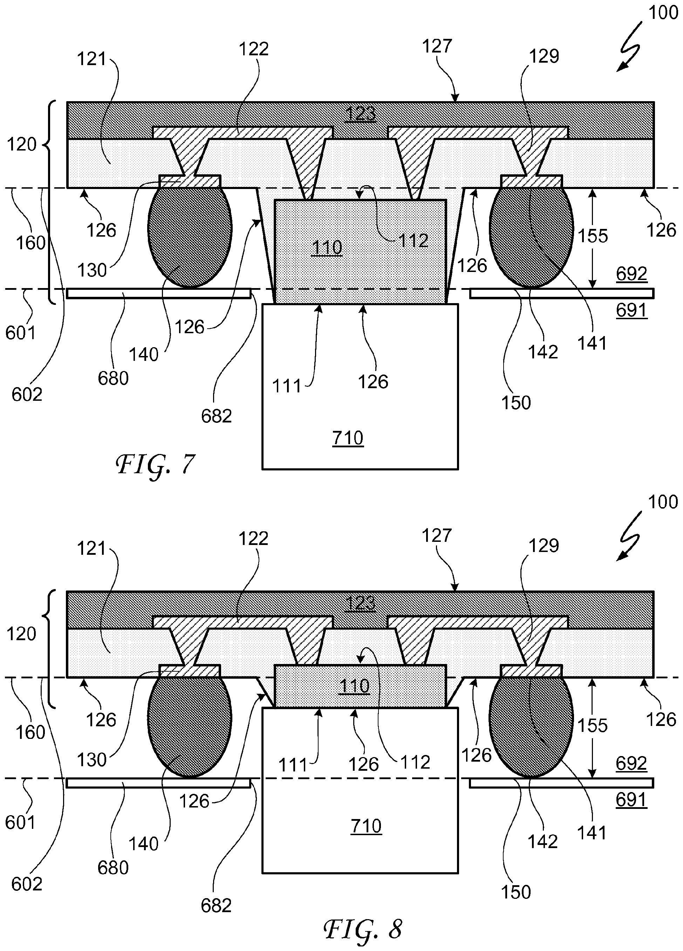

FIGS. 6 and 7 are, respectively, an exploded perspective view and a cross-sectional view of an electronic assembly
FIG. 8 is a cross-sectional view of an electronic assembly according to another embodiment of the invention;

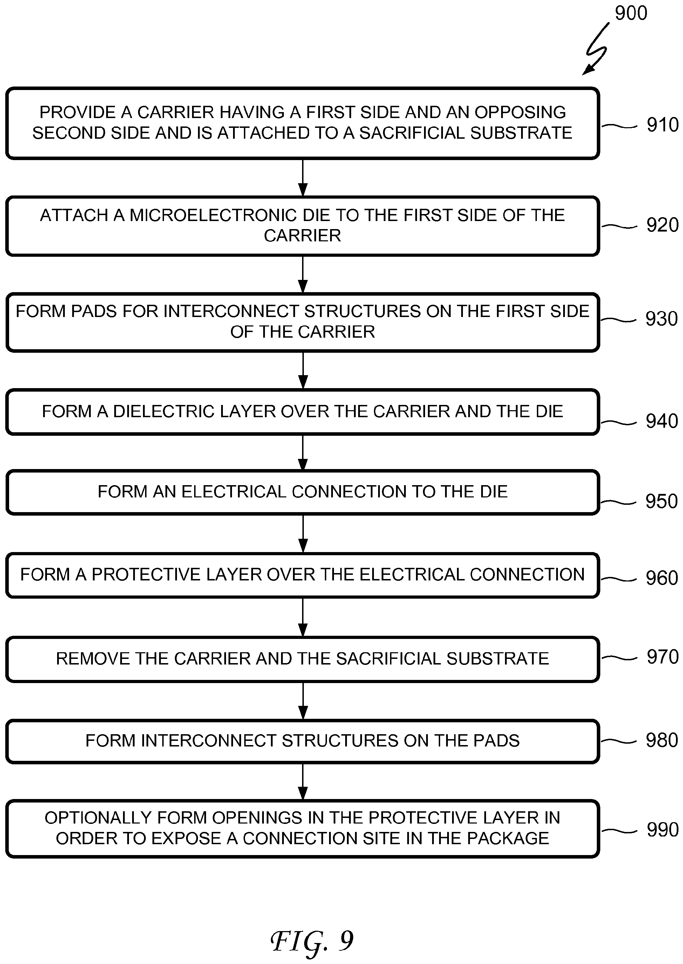

FIG. 9 is a flowchart illustrating a method of manufacturing a package for a microelectronic device according to an embodiment of the invention; and

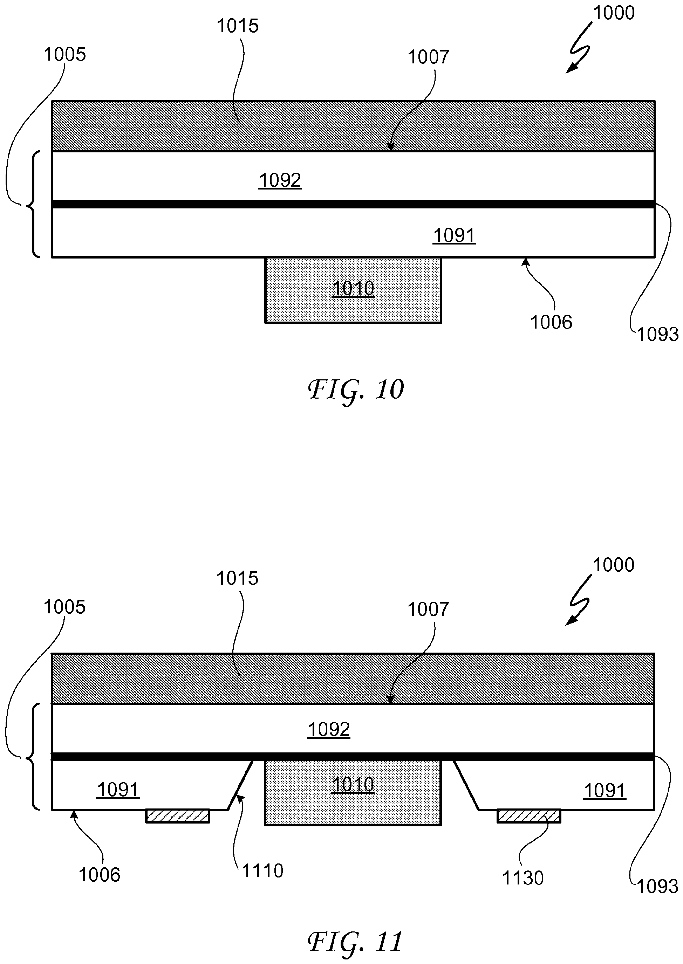

FIGS. 10-16 are cross-sectional views of a portion of a microelectronic package at various stages in its manufacturing process

For simplicity and clarity of illustration, the drawing figures illustrate the general manner of construction, and descriptions and details of well-known features and techniques may be omitted to avoid unnecessarily obscuring the discussion of the described embodiments of the invention. Additionally, elements in the drawing figures are not necessarily drawn to scale. For example, the dimensions of some of the elements in the figures may be exaggerated relative to other elements to help improve understanding of embodiments of the present invention. Certain figures may be shown in an idealized fashion in order to aid understanding, such as when structures are shown having straight lines, sharp angles, and parallel planes that under real-world conditions would be less symmetric and orderly. The same reference numerals in different figures denote the same elements, while similar reference numerals may, but do not necessarily, denote similar elements.

The terms "first," "second," "third," "fourth," and the like in the description and in the claims, if any, are used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Similarly, if a method is described herein as comprising a series of steps, the order of such steps as presented herein is not necessarily the only order in which such steps may be performed, and certain of the stated steps may possibly be omitted and/or certain other steps not described herein may possibly be added to the method. Furthermore, the terms "comprise," "include," "have," and any variations thereof, are intended to cover a non-exclusive inclusion, such that a process, method, article, or apparatus that comprises a list of elements is not necessarily limited to those elements, but may include other elements not expressly listed or inherent to such process, method, article, or apparatus.

The terms "left," "right," "front," "back," "top," "bottom," "over," "under," and the like in the description and in the claims, if any, are used for descriptive purposes and not necessarily for describing permanent relative positions unless otherwise indicated either specifically or by context. It is to be understood that the terms so used are interchangeable under appropriate circumstances such that the embodiments of the invention described herein are, for example, capable of operation in other orientations than those illustrated or otherwise described herein. The term "coupled," as used herein, is defined as directly or indirectly connected in an electrical or non-electrical manner. Objects described herein as being "adjacent to" each other may be in physical contact with each other, in close proximity to each other, or in the same general region or area as each other, as appropriate for the context in which the phrase is used. Occurrences of the phrase "in one embodiment" herein do not necessarily all refer to the same embodiment.

### DETAILED DESCRIPTION OF THE DRAWINGS

In one embodiment of the invention, a low-profile microelectronic package comprises a microelectronic die having a first surface and an opposing second surface and further comprises a package according to claim 1.

It was mentioned above that low package heights are increasingly important for various market segments, including the mobility segment. Embodiments of the invention address that need with an inverted package configuration made using bumpless build-up layer (BBUL) technology that provides for a package height that is significantly less than is possible with existing solutions. In particular embodiments, as will be discussed in detail below, the die is routed out to ball grid array (BGA) pads on the same side of the package as the die, and the die is placed in a space defined by BGA balls attached to the BGA pads. Embodiments of the invention work well for dies having relatively few bumps and relatively low power requirements, where passive cooling would be sufficient, while other embodiments work well with, and may be optimized for, dies having relatively large numbers of bumps and relatively high power requirements (and that may need more robust thermal management solutions).

Referring now to the drawings, FIGs. 1-4 are cross-sectional views of a low-profile microelectronic package 100 As illustrated in FIG. 1, microelectronic package 100 comprises a microelectronic die 110 having a surface 111 and an opposing surface 112. A package substrate 120 is built up around at least a portion of microelectronic die 110 and comprises an electrically insulating layer 121, an electrically conductive layer 122 electrically connected to microelectronic die 110 (e.g., using vias 129), and a protective layer 123 over electrically conductive layer 122. Only one electrically conductive layer is shown, but package 100 could in certain embodiments comprise multiple electrically conductive layers formed and interconnected according to known processes. Protective layer 123 would then be formed over the uppermost/final metal layer. As an example, these electrically conductive layers could be copper layers or other metal layers, perhaps formed using semi-additive process (SAP) techniques or the like. The protective layer protects the underlying conductive layers by preventing electrical shorting, preventing corrosion of the copper or other materials making up the conductive layers, and protects those materials from the elements. As an example, protective layer 123 can comprise a solder resist or the like.

Electrically insulating layer 121, a lower surface of which forms a side 126 of package substrate 120, has a plurality of pads 130 formed therein. A side 127 of package substrate 120-located opposite side 126-is formed by un upper surface of protective layer 123. Surface 111 of microelectronic die 110 is located at side 126 of the package substrate.

Microelectronic package 100 further comprises an array of electrically conductive interconnect structures 140 located at side 126 of package substrate 120. These can be ball grid array (BGA) balls, meaning the pads 130 can be BGA pads. Alternatively, the interconnect structures can be solder grid array (SGA) balls. Each individual interconnect structure in the array has an end 141 and an opposing end 142, and wherein end 141 is connected to one of pads 130. Ends 142 of interconnect structures 140 define a plane 150 located at a distance 155 from pads 130. Surface 111 of die 110 is located at a second distance from pads 130. In one case, this second distance is less than distance 155, while in another case the second distance is greater than distance 155. The first of these two cases may be similar to what is shown in FIG. 1. Because in this first case the die is located within a region or space defined by interconnect structures 140, rather than being attached above protective layer 123, as in conventional architectures, this configuration enables a low-profile package that is a desired outcome of embodiments of the present invention.

The latter of the two cases mentioned above-that is, the case where the second distance is greater than distance 155, or, in other words, where surface 111 of die 110 extends below plane 150-may be accomplished by increasing the thickness of the die, in a manner such as that shown in FIG. 2. Alternatively, it may be accomplished with a die having a thickness similar to that shown in FIG. 1 by manipulating the thicknesses of the various package substrate layers and/or by manipulating the level at which such a (relatively thin) die is located within the package substrate. This latter embodiment, though it has a larger z-height than does the embodiment of FIG. 1, offers a potential advantage in terms of thermal management capabilities, as will be further discussed below.

The package substrate in a BBUL environment is generally considered to include the entire package other than the die itself. As known to those of ordinary skill in the art, BBUL technology involves dies that are embedded within-rather than attached to a surface of-a package substrate. Thus, in BBUL technology, build-up layers are built up around the die, thereby obviating the need for flip-chip bumps or other external die attach mechanisms.

Another feature of BBUL technology is that the depth to which the die is embedded may be adjusted. In terms of embodiments of the present invention, that ability to adjust the die embedding depth (accomplished in ways that will be discussed below), means that microelectronic die 110 may be located at various places within package substrate 120 with respect to some particular reference point. For example, one may use a plane defined by pads 130 as a reference point by which to define the location of microelectronic die 110. Thus, referring again to FIG. 1, pads 130 may be used to define a plane 160 within electrically insulating layer 121. Then, as shown, interconnect structures 140 are on a side 161 of plane 160 and protective layer 123 is on the other side of the plane, i.e., on a side 162.

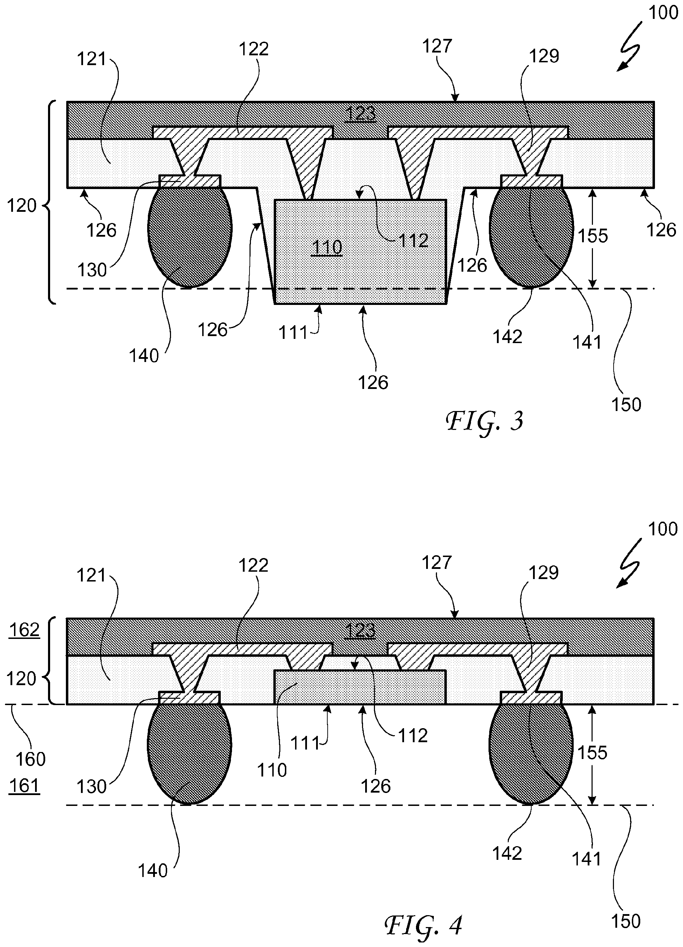

Having defined a frame of reference, various embodiments of microelectronic package 100 may now be set forth as follows. In Fig. 1 and Fig. 2, surface 111 of microelectronic die 110 lies on side 161 of plane 160. This is referred to herein as "partially embedded" In the package according to the invention, surface 111 and surface 112 of microelectronic die 110 both lie on side 161 of plane 160. This is referred to herein as a "fully outside" or "un-embedded" embodiment, and is illustrated in FIG. 3. In Fig. 4, surface 111 of microelectronic die 110 (along with surface 112) is on side 162 of plane 160 (or perhaps lies in plane 160 itself). This is referred to herein as a "fully embedded" configuration, and is illustrated in FIG. 4.

Any or all of the foregoing may offer advantages in terms of a low-profile microelectronic package. Additional advantages may be realized by enabling package-on-package (POP) configurations. POP architecture is an increasingly important trend in certain product categories-including mobile devices-in part because of the space savings and manufacturing advantages that it provides. Embodiments of the present invention enable POP architecture, as discussed below.

FIG. 5 is a cross-sectional view of microelectronic package 100 that enables a POP architecture As illustrated in FIG. 5, protective layer 123 may be opened up (e.g., using standard lithography techniques) so as to expose package-on-package pads 570. These POP pads are shown connecting directly to BGA pads 130, but could alternatively connect to die 110 using routing within the substrate. Pads 570 may be used as attachment points for an upper package such as a memory module or the like (not shown) that is to be stacked on microelectronic package 100 in a POP arrangement.

FIG. 6 is an exploded perspective view and FIG. 7 is a cross-sectional view of an electronic assembly 600 Electronic assembly 600 includes low-profile microelectronic package 100. In FIG. 6, package 100 is represented by a generic block from which most of the details of the previous figures have been omitted (though portions of interconnect structures 140 may be seen). Electronic assembly 600 also comprises a board 680 to which package 100 is attached. (For clarity, package 100 is shown suspended above board 680, with dashed lines indicating the location of its attached position.) The attachment may be made-in accordance with well-known techniques-by bringing interconnect structures 140 and corresponding pads 681 (located on board 680) into contact with each other and reflowing interconnect structures 140 in order to form electrical connections between package and board.

In the illustrated example, board 680 has an opening 682. This opening extends completely through the board and thus allows objects to pass through the middle of the board (i.e., through the opening) from one side of the board to the other. A practical advantage of this configuration, further discussed in the following paragraphs, is that for high-power (or other) applications a thermal management structure, a heat sink for example, may be brought into contact with, or otherwise help dissipate heat from, microelectronic die 110. This is not possible with configurations in which board 680 lacks an opening therein because those configurations do not allow sufficient space for thermal management structures to be placed in contact with the die.

Board 680 defines a lower plane 601 of electronic assembly 600 and pads 130 in electrically insulating layer 121 define an upper plane 602 of the electronic assembly. Note that pads 130 and layer 121, which are depicted in FIGs. 1-5, are not shown in FIG. 6. It should also be noted that upper plane 602 is at least roughly equivalent to plane 160 that was introduced above in a slightly different context. Similarly, lower plane 601 is at least roughly equivalent to plane 150 that was also introduced above in a slightly different context. As illustrated, lower plane 601 has a side 691 and an opposing side 692, with upper plane 602 being located on side 692 of lower plane 601.

In Fig. 7 surface 111 of microelectronic die 110 is located on side 691 of lower plane 601 such that it protrudes through opening 682 in board 680. Also shown in FIG. 7 is a cooling device 710 attached to package 100 such that the cooling device is adjacent to side 111 of die 110. Cooling device 710 can be a heat sink, a heat spreader, a microchannel, or any other suitable thermal management structure.

In Fig. 8, surface 111 of microelectronic die 110 is located on side 692 of lower plane 601. Here, die 110 does not protrude through opening 682. Instead, cooling device 710, or at least a portion thereof, also lies on side 692 of lower plane 601, having been introduced through opening 682 from side 691 after board 680 and package 100 are coupled to each other. (Alternatively, cooling device 710 may be attached to package 100 prior to the attachment of package and board.)

FIG. 9 is a flowchart illustrating a method 900 of manufacturing a package for a microelectronic device according to an embodiment of the invention. As an example, method 900 may result in the formation of a microelectronic package that is similar to microelectronic package 100 that is first shown in FIG. 1. Either wafer-level or panel-level processing may be used. Method 900 is further illustrated in FIGs. 10-16, all of which are cross-sectional views of a package 1000 at various stages in its manufacturing process according to embodiments of the invention. It should be noted that although the figures show one-sided construction, in at least some embodiments manufacturing will be done in parallel in a back-to-back, double-sided manner. A depiction of such double-sided parallel processing would include what is shown in FIGs. 10-13 plus the mirror image of what is shown there, with a sacrificial core in between the two sides.

A step 910 of method 900 is to provide a carrier having a first side and an opposing second side and is attached to a sacrificial substrate. As an example, the carrier can be similar to a carrier 1005 that is shown in FIG. 10. The first side of the carrier can be similar to a side 1006 of carrier 1005, and the second side of the carrier can be similar to a side 1007 of carrier 1005. In one embodiment, the carrier can be a copper foil or the like. As another example, the sacrificial substrate can be similar to a substrate 1015 that is also illustrated in FIG. 10 and that may take the form of a peelable core. This sacrificial substrate allows the part to be handled during manufacturing.

In one embodiment, step 910 comprises providing a multi-layer copper foil or the like comprising a first layer of copper (or another suitable material), a second layer of copper (or another suitable material), and a barrier layer in between the first and second layers. As an example, the first layer, the second layer, and the barrier layer can be similar to, respectively, a layer 1091, a layer 1092, and a layer 1093, all of which are shown in FIG. 10. The barrier layer can comprise, for example, nickel or another suitable metal, build-up film, solder resist, dry film resist, or any other material capable of acting as an etch stop and of defining a flat surface on which to place the die.

A step 920 of method 900 is to attach a microelectronic die to the first side of the carrier. As an example, the microelectronic die can be similar to microelectronic die 110 that is first shown in FIG. 1. As another example, the microelectronic die can be similar to a microelectronic die 1010 that is shown in FIG. 10. In the embodiment illustrated in FIG. 10, step 920 comprises attaching the die to an unaltered carrier 1005, that is, to a carrier that generally has the form shown for it in FIG. 10. In another embodiment, step 920 comprises forming a cavity in the carrier and attaching the microelectronic die in the cavity. This embodiment is illustrated in FIG. 11, where package 1000 is shown to have a cavity 1110 formed in side 1006 of carrier 1005 and where die 1010 is located in cavity 1110.

As an example, the cavity may be formed by patterning a dry film layer that has been laminated onto the carrier according to techniques that are known in the art. The patterning may include an etching procedure, also known in the art, that etches all the way through the first layer of the carrier and stops on the barrier layer. (A thickness of the first layer thus dictates, at least in part, a depth of the cavity.) As another example, the die may be attached in the cavity by dispensing an adhesive onto the carrier, by pre-attaching an adhesive die backside film (DBF) onto the back of the die prior to its placement in the cavity, or by using similar techniques. If desired, the DBF can be provided with metallic particles (e.g., copper or silver) in order to enhance thermal dissipation.

A depth to which the die is embedded within the package substrate depends at least in part on a thickness of the first copper layer and on a corresponding depth of the cavity therein. (This concept will be more fully explored later in this discussion after the relevant structural details have been introduced.) Thus, in one embodiment method 900 further comprises selecting a thickness of the first copper layer based upon at least one of a thickness of the microelectronic die and a depth to which the microelectronic die is to be embedded within the package.

A step 930 of method 900 is to form pads for interconnect structures on the first side of the carrier. As an example, the pads can be similar to pads 130 that are first shown in FIG. 1. As another example, the pads can be similar to pads 1130 that are shown in FIG. 11. The pads, which may in some embodiments comprise copper, may be provided with a desired surface finish (not shown). In one embodiment, a gold-based surface finish may be used.

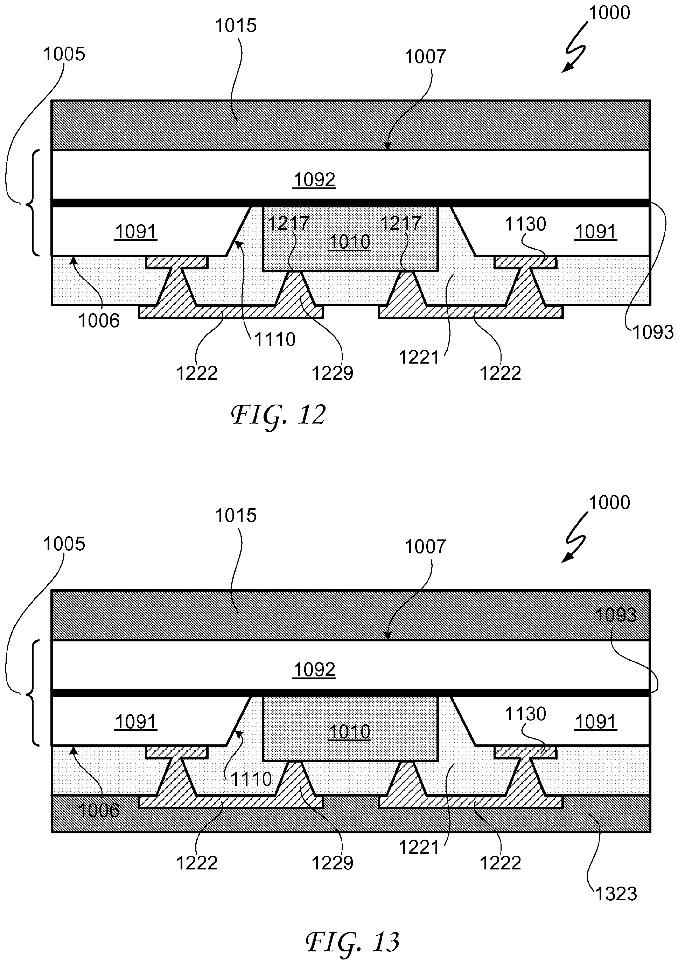

A step 940 of method 900 is to form a dielectric layer over the carrier and the microelectronic die. As an example, the dielectric layer can be similar to electrically insulating layer 121 that is first shown in FIG. 1. As another example, the dielectric layer can be similar to a dielectric layer 1221 that is shown in FIG. 12. In one embodiment, a dielectric film may be laminated (e.g., on an entire panel) providing a level plane for the rest of the build-up process. The carrier may be roughened prior to lamination in order to aid with adhesion to the dielectric film.

A step 950 of method 900 is to form an electrical connection to the microelectronic die. In one embodiment, step 950 comprises forming vias landing on electrically conductive structures of the microelectronic die, plating the vias with an electrically conductive material, and forming a metal layer in the dielectric layer and electrically connecting it to the electrically conductive material in the vias. With reference to FIG. 12, these features are visible as vias 1229, electrically conductive structures 1217, and a metal layer 1222. In a particular embodiment, SAP techniques are used to plate the vias landing on the die pads and the first metal layer of the substrate portion of the package. Additional layers (not shown) may also be used to route out the die bumps to the BGA pads. The use of such additional layers may be dictated by the number of input/output (I/O) bumps needed, by power delivery considerations, and/or by geometrical constraints or other factors.

A step 960 of method 900 is to form a protective layer over the electrical connection. As an example, the protective layer can be similar to protective layer 123 that is first shown in FIG. 1. As another example, the protective layer can be similar to a protective layer 1323 that is shown in FIG. 13.

It was mentioned above that a depth to which the die is embedded within the package substrate depends at least in part on a thickness of the first copper layer and on a corresponding depth of the cavity therein. For example, if no cavity is formed and the die is therefore positioned as shown in FIG. 10, the resulting structure (after package manufacturing has been completed) is what is referred to herein as a fully embedded configuration, meaning the die is located within the dielectric layer roughly between the interconnect structure pads and the protective layer. An example of this configuration was shown in FIG. 4. Accordingly, fully embedding the microelectronic die in the package means, at least in one embodiment, attaching the microelectronic die to a carrier without a cavity. On the other hand, if a cavity is formed and the die is therefore positioned as shown in FIG. 11, the resulting structure (after package manufacturing has been completed) is what is referred to herein as a partially embedded configuration, meaning one surface of the die is located on one side of the interconnect structure pads and another surface of the die is located on another side of the interconnect structure pads. Examples of this configuration were shown in FIGs. 1 and 2. Accordingly, partially embedding the microelectronic die in the package means attaching the microelectronic die to a carrier inside of a cavity having a particular depth. If the depth is great enough and/or depending on a thickness of the die-see FIG. 3-the result may be what is referred to herein as an un-embedded configuration.

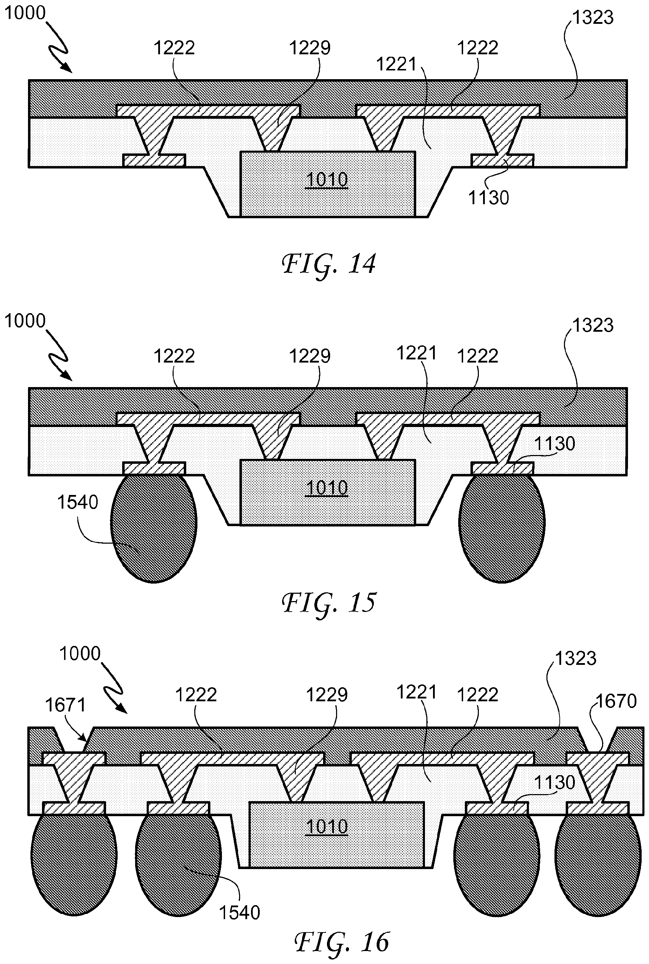

A step 970 of method 900 is to remove the carrier and the sacrificial substrate. As an example, the removal may be accomplished using an etching process. After this is done, and the remaining structure is inverted, package 1000 appears as shown in FIG. 14.

A step 980 of method 900 is to form interconnect structures on the pads. This may be done using standard ball attach processes. As an example, the interconnect structures can be similar to interconnect structures 140 that are first shown in FIG. 1. As another example, the interconnect structures can be similar to interconnect structures 1540 that are shown in FIG. 15.

An optional step 990 of method 900 is to form openings in the protective layer in order to expose a connection site in the package. The connection site may be used, for example, as a connection point to which may be attached an additional microelectronic package in a POP architecture or the like. As an example, the connection site can be similar to package-on-package pads 570 that are shown in FIG. 5. As another example, the connection site can be similar to a connection site 1670 that is shown in FIG. 16. The openings in the protective layer can be similar to, for example, openings 1671 that are also shown in FIG. 16.

## Claims

1. A low-profile microelectronic package comprising:
a microelectronic die (110) having a first surface (111) and an opposing second surface (112);
a package substrate (120) built up around at least a portion of the microelectronic die, the package substrate comprising:
an electrically insulating layer (121) that forms a first side of the package substrate, the electrically insulating layer having a plurality of pads (130) formed therein, wherein the first surface of the microelectronic die is located at the first side of the package substrate;
an electrically conductive layer (122) electrically connected to the microelectronic die; and
a protective layer (123) over the electrically conductive layer, the protective layer forming a second side of the package substrate; and
an array of electrically conductive interconnect structures (140) located at the first side of the package substrate, wherein each individual interconnect structure in the array of electrically conductive interconnect structures has a first end (141) and an opposing second end (142), and wherein the first end is connected to one of the plurality of pads;
**characterized in that**
the pads define a plane (160) within the electrically insulating layer; and the array of electrically conductive interconnect structures is on a first side (161) of the plane and the protective layer is on a second side (162) of the plane; and the first surface and the second surface of the microelectronic die are on the first side of the plane.

2. The low-profile microelectronic package of claim 1 wherein: the second ends of the electrically conductive interconnect structures define a plane located at a first distance from the pads; the first surface of the die is located at a second distance from the pads; and the second distance is less than the first distance.

3. The low-profile microelectronic package of claim 1 further comprising: package-on-package pads exposed in the protective layer.

4. The low-profile microelectronic package of claim 1 wherein: the second ends of the electrically conductive interconnect structures define a plane located at a first distance from the pads; the first surface of the die is located at a second distance from the pads; and the second distance is greater than the first distance.

5. The low-profile microelectronic package of claim 1, comprising a board, wherein the board is attached to the low-profile microelectronic package using the array of electrically conductive interconnect structures.

6. The low-profile microelectronic package of claim 5 wherein: the board has an opening therein; the board defines a lower plane of the electronic assembly and the plurality of pads in the electrically insulating layer define an upper plane of the electronic assembly; the lower plane has a first side and an opposing second side, with the upper plane being located on the second side of the lower plane; the first surface of the microelectronic die is located on the first side of the lower plane such that it protrudes through the opening in the board; the electronic assembly further comprising: a cooling device attached to the low-profile microelectronic package such that it is adjacent to the first side of the microelectronic die.

7. A method of manufacturing a package for a microelectronic device, the method comprising:
providing a carrier (1005) attached to a sacrificial substrate (1015), the carrier having a first side (1006) and an opposing second side (1007);
attaching a microelectronic die (1010) to the first side of the carrier, the microelectronic die having a first side and an opposing second side;
forming pads (1130) for interconnect structures on the first side of the carrier;
forming a dielectric layer (1221) over the carrier and the microelectronic die, wherein the dielectric layer is a electrically insulating layer; wherein the pads define a plane within the electrically insulating layer;
forming an electrical connection to the microelectronic die;
forming a protective layer (1323) over the electrical connection wherein the protective layer is on a second side of the plane; and
removing the carrier and the sacrificial substrate;
forming an array of electrically conductive interconnect structures (1540), wherein the array of electrically conductive interconnect structures is on a first side of the plane;
**characterized in**
the step of arranging the first surface of the microelectronic die and the second surface of the microelectronic die on the first side of the plane.

8. The method of claim 7 wherein: providing the carrier comprises providing a multilayer copper foil comprising a first copper layer, a second copper layer, and a barrier layer in between the first and second copper layers.

9. The method of claim 8 further comprising: selecting a thickness of the first copper layer based upon at least one of a thickness of the microelectronic die and a depth to which the microelectronic die is to be embedded within the package.

10. The method of claim 7 wherein: attaching the microelectronic die to the carrier comprises: forming a cavity in the carrier; and attaching the microelectronic die in the cavity.

11. The method of claim 7 wherein: forming the electrical connection to the microelectronic die comprises: forming vias landing on electrically conductive structures of the microelectronic die; plating the vias with an electrically conductive material; and forming a metal layer in the dielectric layer and electrically connecting it to the electrically conductive material in the vias.

12. The method of claim 7 further comprising: forming openings in the protective layer in order to expose a connection site.

## Patentansprüche

1. Flaches mikroelektronisches Gehäuse, umfassend:
einen mikroelektronischen Chip (Die) (110), der eine erste Oberfläche (111) und eine gegenüber liegende zweite Oberfläche (112) aufweist;
ein Gehäusesubstrat (120), das um mindestens einen Anteil des mikroelektronischen Dies herum aufgebaut ist, wobei das Gehäusesubstrat umfasst:
eine elektrisch isolierende Schicht (121), die eine erste Seite des Gehäusesubstrats bildet, wobei die elektrisch isolierende Schicht eine Vielzahl von darin gebildeten Kontaktstellen (Pads) (130) aufweist, wobei die erste Oberfläche des mikroelektronischen Dies sich an der ersten Seite des Gehäusesubstrats befindet;
eine elektrisch leitfähige Schicht (122), die elektrisch mit dem mikroelektronischen Die verbunden ist; und
eine Schutzschicht (123) über der elektrisch leitfähigen Schicht, wobei die Schutzschicht eine zweite Seite des Gehäusesubstrats bildet; und
eine Gruppierung von elektrisch leitfähigen Verschaltungsstrukturen (140), die sich an der ersten Seite des Gehäusesubstrats befinden, wobei jede einzelne Verschaltungsstruktur in der Gruppierung der elektrisch leitfähigen Verschaltungsstrukturen ein erstes Ende (141) und ein gegenüber liegendes zweites Ende (142) aufweist, und wobei das erste Ende mit einem von der Vielzahl der Pads verbunden ist;
**dadurch gekennzeichnet, dass**
die Pads eine Ebene (160) innerhalb der elektrisch isolierenden Schicht definieren; und
die Gruppierung der elektrisch leitfähigen Verschaltungsstrukturen sich auf einer ersten Seite (161) der Ebene befindet, und die Schutzschicht sich auf einer zweiten Seite (162) der Ebene befindet; und
die erste Oberfläche und die zweite Oberfläche des mikroelektronischen Dies sich auf der ersten Seite der Ebene befinden.

2. Flaches mikroelektronisches Gehäuse nach Anspruch 1, wobei:
die zweiten Enden der elektrisch leitfähigen Verschaltungsstrukturen eine Ebene definieren, die sich in einem ersten Abstand zu den Pads befindet;
die erste Oberfläche des Dies sich in einem zweiten Abstand zu den Pads befindet; und
der zweite Abstand kleiner als der erste Abstand ist.

3. Flaches mikroelektronisches Gehäuse nach Anspruch 1, des Weiteren umfassend:
Gehäuse-auf-Gehäuse- (Package-on-Package, PoP)-Pads, die in der Schutzschicht freigelegt sind.

4. Flaches mikroelektronisches Gehäuse nach Anspruch 1, wobei:
die zweiten Enden der elektrisch leitfähigen Verschaltungsstrukturen eine Ebene definieren, die sich in einem ersten Abstand zu den Pads befindet;
die erste Oberfläche des Dies sich in einem zweiten Abstand zu den Pads befindet; und
der zweite Abstand größer als der erste Abstand ist.

5. Flaches mikroelektronisches Gehäuse nach Anspruch 1, umfassend eine Platine, wobei die Platine unter Verwendung der Gruppierung von elektrisch leitfähigen Verschaltungsstrukturen an dem flachen mikroelektronischen Gehäuse befestigt ist.

6. Flaches mikroelektronisches Gehäuse nach Anspruch 5, wobei:
die Platine eine Öffnung darin aufweist;
die Platine eine untere Ebene der elektronischen Baugruppe definiert, und die Vielzahl von Pads in der elektrisch isolierenden Schicht eine obere Ebene der elektrischen Baugruppe definieren;
die untere Ebene eine erste Seite und eine gegenüber liegende zweite Seite aufweist, wobei die obere Ebene sich auf der zweiten Seite der unteren Ebene befindet;
die erste Oberfläche des mikroelektronischen Dies sich auf der ersten Seite der unteren Ebene befindet, so dass sie durch die Öffnung in der Platine ragt;
die elektronische Baugruppe des Weiteren umfasst:
eine Kühlvorrichtung, die an dem flachen mikroelektronischen Gehäuse befestigt ist, so dass sie sich neben der ersten Seite des mikroelektronischen Dies befindet.

7. Verfahren zur Fertigung eines Gehäuses für eine mikroelektronischen Vorrichtung, wobei das Verfahren umfasst:
Bereitstellen eines Trägers (1005), der an einem Opfersubstrat (1015) befestigt ist, wobei der Träger eine erste Seite (1006) und eine gegenüber liegende zweite Seite (1007) aufweist;
Befestigen eines mikroelektronischen Dies (1010) an der ersten Seite des Trägers, wobei der mikroelektronische Die eine erste Seite und eine gegenüber liegende zweite Seite aufweist;
Bilden von Pads (1130) für Verschaltungsstrukturen auf der ersten Seite des Trägers;
Bilden einer dielektrischen Schicht (1221) über dem Träger und dem mikroelektronischen Die, wobei die dielektrische Schicht eine elektrisch isolierende Schicht ist;
die Pads eine Ebene innerhalb der elektrisch isolierenden Schicht definieren;
Bilden einer elektrischen Verbindung zu dem mikroelektronischen Die;
Bilden einer Schutzschicht (1323) über der elektrischen Verbindung, wobei die Schutzschicht sich auf einer zweiten Seite der Ebene befindet; und
Entfernen des Trägers und des Opfersubstrats;
Bilden einer Gruppierung von elektrisch leitfähigen Verschaltungsstrukturen (1540), wobei die Gruppierung der elektrisch leitfähigen Verschaltungsstrukturen sich auf einer ersten Seite der Ebene befindet;
**gekennzeichnet durch**
den Schritt des Anordnens der ersten Oberfläche des mikroelektronischen Dies und der zweiten Oberfläche des mikroelektronischen Dies auf der ersten Seite der Ebene.

8. Verfahren nach Anspruch 7, wobei:
Bereitstellen des Trägers Bereitstellen einer mehrschichtigen Kupferfolie umfasst, die eine erste Kupferschicht, eine zweite Kupferschicht und eine Barriereschicht zwischen der ersten und der zweiten Kupferschicht umfasst.

9. Verfahren nach Anspruch 8, ferner umfassend:
Auswählen einer Dicke der ersten Kupferschicht basierend auf mindestens einer von einer Dicke des mikroelektronischen Dies und einer Tiefe, in der der mikroelektronische Die in dem Gehäuse eingebettet werden soll.

10. Verfahren nach Anspruch 7, wobei:
Befestigen des mikroelektronischen Dies an dem Träger umfasst:
Bilden eines Hohlraums in dem Träger; und
Befestigen des mikroelektronischen Dies in dem Hohlraum.

11. Verfahren nach Anspruch 7, wobei:
Bilden der elektrischen Verbindung zu dem mikroelektronischen Die umfasst:
Bilden von Durchkontaktierungen (Vias) auf elektrisch leitfähigen Strukturen des mikroelektronischen Dies;
Plattieren der Vias mit einem elektrisch leitfähigen Material; und
Bilden einer Metallschicht in der dielektrischen Schicht, und elektrisches Verbinden derselben mit dem elektrisch leitfähigen Material in den Vias.

12. Verfahren nach Anspruch 7, ferner umfassend:
Bilden von Öffnungen in der Schutzschicht, um eine Verbindungsstelle freizulegen.

## Revendications

1. Boîtier microélectronique extra-plat comprenant :
une puce microélectronique (110) ayant une première surface (111) et une deuxième surface opposée (112) ;
un substrat de boîtier (120) construit autour d'au moins une partie de la puce microélectronique, le substrat de boîtier comprenant :
une couche électriquement isolante (121) qui forme un premier côté du substrat de boîtier, la couche électriquement isolante ayant une pluralité de plages d'accueil (130) formées à l'intérieur, la première surface de la puce microélectronique étant située sur le premier côté du substrat de boîtier ;
une couche électriquement conductrice (122) raccordée électriquement à la puce microélectronique ; et
une couche protectrice (123) par-dessus la couche électriquement conductrice, la couche protectrice formant un deuxième côté du substrat de boîtier ; et
un réseau de structures d'interconnexion électriquement conductrices (140) situées sur le premier côté du substrat de boîtier, chaque structure d'interconnexion individuelle dans le réseau de structures d'interconnexion électriquement conductrices ayant une première extrémité (141) et une deuxième extrémité opposée (142), et la première extrémité étant raccordée à une de la pluralité de plages d'accueil ;
**caractérisé en ce que**
les plages d'accueil définissent un plan (160) à l'intérieur de la couche électriquement isolante ; et le réseau de structures d'interconnexion électriquement conductrices est sur un premier côté (161) du plan et la couche protectrice est sur un deuxième côté (162) du plan ; et la première surface et la deuxième surface de la puce microélectronique sont sur le premier côté du plan.

2. Boîtier microélectronique extra-plat de la revendication 1 dans lequel : les deuxièmes extrémités des structures d'interconnexion électriquement conductrices définissent un plan situé à une première distance des plages d'accueil ; la première surface de la puce est située à une deuxième distance des plages d'accueil ; et la deuxième distance est inférieure à la première distance.

3. Boîtier microélectronique extra-plat de la revendication 1 comprenant en outre : des plages d'accueil boîtier sur boîtier exposées dans la couche protectrice.

4. Boîtier microélectronique extra-plat de la revendication 1 dans lequel : les deuxièmes extrémités des structures d'interconnexion électriquement conductrices définissent un plan situé à une première distance des plages d'accueil ; la première surface de la puce est située à une deuxième distance des plages d'accueil ; et la deuxième distance est supérieure à la première distance.

5. Boîtier microélectronique extra-plat de la revendication 1, comprenant une carte, la carte étant fixée au boîtier microélectronique extra-plat au moyen du réseau de structures d'interconnexion électriquement conductrices.

6. Boîtier microélectronique extra-plat de la revendication 5 dans lequel : la carte renferme une ouverture ; la carte définit un plan inférieur de l'ensemble électronique et la pluralité de plages d'accueil dans la couche électriquement isolante définissent un plan supérieur de l'ensemble électronique ; le plan inférieur a un premier côté et un deuxième côté opposé, avec le plan supérieur situé sur le deuxième côté du plan inférieur ; la première surface de la puce microélectronique est située sur le premier côté du plan inférieur de telle sorte qu'elle fait saillie par l'ouverture dans la carte ; l'ensemble électronique comprenant en outre : un dispositif de refroidissement fixé au boîtier microélectronique extra-plat de telle sorte qu'il est adjacent au premier côté de la puce microélectronique.

7. Procédé de fabrication d'un boîtier pour un dispositif microélectronique, le procédé comprenant :
l'obtention d'un support (1005) fixé à un substrat sacrificiel (1015), le support ayant un premier côté (1006) et un deuxième côté opposé (1007) ;
la fixation d'une puce microélectronique (1010) au premier côté du support, la puce microélectronique ayant un premier côté et un deuxième côté opposé ;
la formation de plages d'accueil (1130) pour des structures d'interconnexion sur le premier côté du support ;
la formation d'une couche diélectrique (1221) par-dessus le support et la puce microélectronique, la couche diélectrique étant une couche électriquement isolante ; les plages d'accueil définissant un plan à l'intérieur de la couche électriquement isolante ;
la formation d'un raccordement électrique à la puce microélectronique ;
la formation d'une couche protectrice (1323) par-dessus le raccordement électrique, la couche protectrice étant sur un deuxième côté du plan ; et
le retrait du support et du substrat sacrificiel ;
la formation d'un réseau de structures d'interconnexion électriquement conductrices (1540), le réseau de structures d'interconnexion électriquement conductrices étant sur un premier côté du plan ;
**caractérisé par**
l'étape d'agencement de la première surface de la puce microélectronique et de la deuxième surface de la puce microélectronique sur le premier côté du plan.

8. Procédé de la revendication 7 dans lequel : l'obtention du support comprend l'obtention d'une feuille de cuivre multicouche comprenant une première couche de cuivre, une deuxième couche de cuivre, et une couche barrière entre les première et deuxième couches de cuivre.

9. Procédé de la revendication 8 comprenant en outre : la sélection d'une épaisseur de la première couche de cuivre sur la base d'une épaisseur de la puce microélectronique et/ou d'une profondeur à laquelle la puce microélectronique doit être incorporée à l'intérieur du boîtier.

10. Procédé de la revendication 7 dans lequel : la fixation de la puce microélectronique au support comprend : la formation d'une cavité dans le support ; et la fixation de la puce microélectronique dans la cavité.

11. Procédé de la revendication 7 dans lequel : la formation du raccordement électrique à la puce microélectronique comprend : la formation de trous d'interconnexion débouchant sur des structures électriquement conductrices de la puce microélectronique ; le placage des trous d'interconnexion avec un matériau électriquement conducteur ; et la formation d'une couche métallique dans la couche diélectrique et le raccordement électrique de celle-ci au matériau électriquement conducteur dans les trous d'interconnexion.

12. Procédé de la revendication 7 comprenant en outre : la formation d'ouvertures dans la couche protectrice afin d'exposer un site de raccordement.
